**Europäisches Patentamt**

**European Patent Office**

**Office européen des brevets**

(19)

(11) Veröffentlichungsnummer : **0 417 392 B1**

(12) # EUROPÄISCHE PATENTSCHRIFT

(45) Veröffentlichungstag der Patentschrift :
08.12.93 Patentblatt 93/49

(51) Int. Cl.$^5$ : **G01D 5/16,** G01R 27/02

(21) Anmeldenummer : **90109049.8**

(22) Anmeldetag : **14.05.90**

(54) **Ausgangsschaltung für ein Potentiometer.**

(30) Priorität : **12.09.89 DE 3930417**

(43) Veröffentlichungstag der Anmeldung :
**20.03.91 Patentblatt 91/12**

(45) Bekanntmachung des Hinweises auf die
Patenterteilung :
**08.12.93 Patentblatt 93/49**

(84) Benannte Vertragsstaaten :
**DE FR GB**

(56) Entgegenhaltungen :
**EP-A- 0 354 269**
**DE-A- 3 522 775**

(73) Patentinhaber : **VDO Adolf Schindling AG**
**Gräfstrasse 103**
**D-60487 Frankfurt (DE)**

(72) Erfinder : **Hannappel, Joachim**
**Blumenstrasse 21**
**D-6251 Waldbrunn 4 (DE)**
Erfinder : **Wiese, Klaus**
**Niederhofheimer Weg 5**
**D-6231 Sulzbach/Ts. (DE)**

(74) Vertreter : **Klein, Thomas, Dipl.-Ing. (FH) et al**
**Sodener Strasse 9**
**D-65824 Schwalbach/Ts. (DE)**

## Beschreibung

Die Erfindung betrifft eine Ausgangsschaltung für ein Potentiometer, insbesondere eines in einer Reihenschaltung mit weiteren Widerständen liegenden Potentiometers, welches zwischen einer Spannungsversorgung und Masse liegt, wobei die zwischen Potentiometerabgriff und Masse abfallende Spannung ein Eingangspotential der Ausgangsschaltung darstellt.

Potentiometer können zur Erfassung einer mechanischen Größe, beispielsweise eines eingestellten Winkels zwischen zwei Teilen verwendet werden. Dabei ist der Abgriff oder Schleifer des Potentiometers mit dem einen Teil und der Widerstandskörper des Potentiometers mit dem anderen Teil verbunden. Die Spannung, die am Eingang des Potentiometers, d. h. über den Widerstandskörper, anliegt, wird durch den Abgriff bzw. den Schleifer geteilt. Die Größe der Spannung am Abgriff bzw. das Verhältnis der Größe der Spannung am Abgriff zu der Größe der Spannung am Eingang des Potentiometers ist ein Maß für die Position des Abgriffs auf der Widerstandsbahn und damit ein Maß für den durch das Potentiometer gemessenen Winkel. Die Auswertung der gemessenen Größe erfolgt, insbesondere bei Verwendung eines derartigen Potentiometers in Kraftfahrzeugen, in der Regel nicht am Meßort, sondern in einer räumlich entfernt angeordneten Auswerteeinheit. Die Auswerteeinheit ist mit dem Potentiometer über elektrische Leitungen verbunden. Wegen der erhöhten mechanischen Beanspruchung der Leitungen in Kraftfahrzeugen besteht die Gefahr, daß die Leitungen schadhaft werden und einen Kurzschluß verursachen oder unterbrochen werden. Der Kurzschluß kann dabei sowohl zu Masse als auch zur Versorgungsspannung hin entstehen.

Gemäß DE-OS 35 22 775 ist eine Vorrichtung zur Bestimmung des Übergangswiderstandes am Abgriff eines Potentiometers bekannt, mittels welcher die beschriebenen Störungen von einer Auswerteeinheit erkannt werden. Zur Erkennung von Kurzschlüssen und Leitungsbrüchen wird das Potentiometer in einer Reihenschaltung mit anderen Widerständen zwischen Versorgungsspannung und Masse geschaltet. Die Auswerteschaltung wird durch einen Mikroprozessor realisiert, welcher die Spannung am Potentiometerabgriff mit einer Testspannung vergleicht.

In der EP-A-0 354 269 wird ebenfalls ein Spannungsvergleich durchgeführt, um den Übergangswiderstand am Abgriff eines als Stellungsgeber dienenden Potentiometers zu überwachen. Dabei wird die Spannung am Potentiometerabgriff mit einem Widerstand belastet und der Unterschied zwischen den bei Belastung und ohne Belastung anliegenden Spannungen ausgewertet.

Bei Potentiometern ohne Endanschlag besteht darüber hinaus die Gefahr, daß der Abgriff mechanisch so weit bewegt wird, daß er die Widerstandsbahn verläßt oder von der Widerstandsbahn abhebt. Der Ausgang des Potentiometers, d. h. das Potential am Abgriff, ist dann nicht mehr definiert.

Die bekannten Lösungen weisen den Nachteil auf, daß eine Unterscheidung zwischen Leitungsabriß und dem Verlassen der Widerstandsbahn durch den Abgriff nicht getroffen werden kann. Auch dieser Zustand sollte von der Auswerteeinrichtung erkannt werden können.

Es ist eine Aufgabe der vorliegenden Erfindung, eine Ausgangsschaltung für ein Potentiometer anzugeben, die eine Ausgangsspannung erzeugt, die es einer Auswerteeinrichtung erlaubt, Störungen zu erfassen.

Diese Aufgabe wird durch eine Ausgangsschaltung für ein Potentiometer gelöst, die an ihrem Ausgang in Abhängigkeit von der Stellung des Abgriffs des Potentiometers ein Potential erzeugt, mit einem Kennlinienbildner, dessen Eingang mit dem Abgriff des Potentiometers und dessen Ausgang mit dem Ausgang der Ausgangsschaltung verbunden ist und der an seinem Ausgang ein Ausgangspotential in Abhängigkeit von dem Eingangspotential an seinem Eingang erzeugt, wobei sich das Ausgangspotential in einem Ausgangsbereich von einem vorbestimmten Minimalwert bis zu einem vorbestimmten Maximalwert bewegt, mit einer Potentialsteuerschaltung, die bei unterbrochenem Stromfluß über den Abgriff des Potentiometers am Abgriff ein vorbestimmtes erstes Potential erzeugt, das größer als das Potentiometerpotential am Eingang des Potentiometers ist, und mit einer Hilfsschaltung, die parallel zum Kennlinienbildner zwischen den Abgriff des Potentiometers und den Ausgang der Ausgangsschaltung geschaltet ist und den Ausgang der Ausgangsschaltung auf ein vorbestimmtes zweites Potential, das außerhalb des Ausgangsbereichs des Kennlinienbildners liegt, bringt, wenn das Potential am Abgriff des Potentiometers einen vorbestimmten Bereich verläßt.

Im Normalzustand, d.h. wenn sich der Abgriff des Potentiometers auf der Widerstandsbahn befindet, ist das Potential am Abgriff definiert. Es ist kleiner als das Eingangspotential des Potentiometers, d.h. das Potential am Abgriff des Potentiometers liegt zwischen den Potentialen an den beiden anderen Anschlüssen des Potentiometers. In Kraftfahrzeugen werden üblicherweise alle Potentiale auf Masse bezogen, so daß man im folgenden ohne weiteres den Begriff "Potential" durch den Begriff "Spannung gegenüber Masse" ersetzen kann. Das Massepotential entspricht dann einer Spannung von Null. Der Kennlinienbildner erzeugt in Abhängigkeit vom Potential am Abgriff des Potentiometers eine Ausgangsspannung der Ausgangsschaltung, solange sich der Abgriff des Potentiometers auf der Widerstandsbahn befindet, d.h. solange das Potential am Abgriff zwischen Eingangspotential und Massepotential des Potentiometers ist. Die Auswerteeinrichtung verfügt über die Information, wie die Kennlinie aussieht. Sie kann daher jeder Ausgangsspannung der Ausgangsschaltung eine bestimmte Position des Abgriffs auf dem Widerstandskörper zuordnen. Wenn die Ausgangsspannung einen Wert annimmt, der nicht auf der Kennlinie vorgesehen ist, kann die Auswerteeinrichtung einen Fehler detektieren. Bei geeigneter Wahl der Kennlinie ist es möglich, sowohl einen Kurzschluß zu erkennen, bei dem die Ausgangsspannung bzw. das Ausgangspotential der Ausgangsschaltung den Wert Null hat, d.h. das Massepotential annimmt, oder bei dem die Ausgangsspannung der Ausgangsschaltung gleich der Versorgungsspannung ist, d.h. bei einem Kurzschluß der Signalleitung zu einer Versorgungsleitung hin. Bei einem Leitungsabriß entsteht ebenfalls ein Potential auf der Leitung zur Auswerteschaltung, das nicht in der Kennlinie vorgesehen ist. Auf diese Weise ist es möglich, daß die Auswerteeinrichtung diese Art von Störungen erkennt. Wenn der Abgriff des Potentiometers die Widerstandsbahn verläßt, was insbesondere bei Leitplastikpotentiometern ohne Endanschlag der Fall sein kann, die wegen ihres geringen Gewichts, ihrer hohen Qualität und ihrer langen Lebensdauer bevorzugt im Kraftfahrzeug verwendet werden, würde ohne zusätzliche Maßnahmen am Ausgang der Ausgangsschaltung der gleiche Zustand auftreten, als ob die Leitung zur Auswerteeinrichtung unterbrochen wäre. Um der Auswerteeinrichtung mitzuteilen, daß keine Leitungsunterbrechung stattgefunden hat sondern der Abgriff lediglich eine Position eingenommen hat, in der er keinen Kontakt mit der Widerstandsbahn mehr hat, ist die Potentialsteuerschaltung und die Hilfsschaltung vorgesehen, die zusammenwirken, um den Ausgang der Ausgangsschaltung für diesen Fall in einen vorbestimmten Zustand zu versetzen, der von der Auswerteeinrichtung ebenfalls erkannt werden kann. Wenn der Abgriff die Widerstandsbahn verläßt, was beispielsweise auch dadurch geschehen kann, daß der Abgriff durch Erschütterungen von der Widerstandsbahn abhebt, wird der Stromfluß über den Abgriff unterbrochen. Für diesen Fall ist die Potentialsteuerschaltung in der Lage, ein vorbestimmtes erstes Potential am Abgriff zu erzeugen, das größer als das Eingangspotential am Eingang des Potentiometers ist. Damit wird zwar der Eingangsbereich des Kennlinienbildners überschritten. Dies ist jedoch unerheblich, da die Ausgangsspannung der Ausgangsschaltung ohnehin nicht mehr vom Kennlinienbildner sondern von der Hilfsschaltung bestimmt wird. Die Hilfsschaltung detektiert nämlich das Potential am Abgriff und bringt das Ausgangspotential der Ausgangsschaltung auf einen vorbestimmten Wert, beispielsweise 0,2 Volt, wenn das Potential am Abgriff seinen üblichen Bereich verläßt. Das Ausgangspotential kann dabei so gewählt werden, daß es der Auswerteschaltung möglich ist, zwischen einem Kurzschluß und dem Zustand zu unterscheiden, in dem der Abgriff des Potentiometers keinen Kontakt mehr mit der Widerstandsbahn hat. Das Ausgangspotential ist dann größer als Null aber kleiner als der kleinste Ausgangswert der Kennlinie.

In einer bevorzugten Ausführungsform erzeugt der Kennlinienbildner eine Ausgangsspannung, die linear von der Eingangsspannung abhängt. Dies erleichtert die Auswertung der Ausgangsspannung durch die Auswerteeinrichtung.

Mit Vorteil ist der Ausgangsbereich des Kennlinienbildners kleiner als sein Eingangsbereich. Dies ist insbesondere in Kraftfahrzeugen von Vorteil, wo im wesentlichen nur eine Spannung, nämlich die Spannung des Bordnetzes, die durch die Batterie bestimmt wird, zur Verfügung steht. Dadurch, daß der Ausgangsbereich des Kennlinienbildners kleiner als der Eingangsbereich ist, stehen an der oberen und-/oder unteren Grenze noch Spannungsdifferenzen zur Verfügung, die zur Erfassung eines Leitungsbruchs oder Kurzschlusses von der Auswerteeinrichtung erfaßt werden können.

In einer bevorzugten Ausführungsform hängt das Potential $P_A$ am Ausgang des Kennlinienbildners durch folgende Funktion vom Potential $P_E$ am Eingang des Kennlinienbildners ab:

$$P_A = P_O (P_E - P_O) \times v$$

wobei $P_O$ ein vorbestimmtes drittes Potential und v ein Verstärkungsfaktor kleiner 1 ist. Damit läßt sich eine lineare Ausgangskennlinie erreichen, wobei der Wertebereich des Ausgangspotentials kleiner als der Wertebereich des Eingangspotentials ist.

In einer bevorzugten Ausführungsform weist die Potentialsteuerschaltung eine insbesondere eine Zenerdiode aufweisende Konstantspannungsquelle auf, deren Ausgang über einen Widerstand hochohmig mit dem Abgriff des Potentiometers verbunden ist. Solange der Abgriff mit der Widerstandsbahn des Potentiometers in Verbindung steht, fließt ein Strom von der Konstantspannungsquelle über den Widerstand und das Potentiometer. Über den Widerstand wird ein Spannungsabfall erzeugt, so daß das Potential am Abgriff des Potentiometers im wesentlichen durch die Position des Abgriffs auf dem Widerstandskörper und das Eingangspotential des Potentiometers bestimmt wird. In dem Augenblick, wo der Stromfluß unterbrochen ist, weil sich der Abgriff des Potentiometers nicht mehr auf der Widerstandsbahn befindet, nimmt das Potential am Abgriff das Ausgangspotential der Konstantspannungsquelle an.

Dabei ist es von Vorteil, daß der Widerstandswert des Widerstands um einen Faktor in der Größenordnung von 1000 größer ist als der Gesamtwiderstandswert des Potentiometers. Im ungünstigsten Fall, d.h. wenn sich der Abgriff des Potentiometers an dem Ende des Potentiometers befindet, an dem das Eingangspotential anliegt, ergibt sich damit ein Fehler von ca. 1 Promille für das Potential am Abgriff.

In einer bevorzugten Ausführungsform weist die Hilfsschaltung einen Komparator auf, der das Potential am Abgriff des Potentiometers mit einem Bezugspotential vergleicht und ein Ausgangssignal erzeugt, wenn das Potential am Abgriff in einer vorbestimmten Richtung vom Bezugspotential abweicht, wobei eine Schalteinrichtung vorgesehen ist, die auf das Augangssignal des Komparators hin den Ausgang der Ausgansschaltung auf das vorbestimmte zweite Potential bringt. Dabei ist es von Vorteil, daß das Bezugspotential das Eingangspotential des Potentiometers ist. Solange der Abgriff mit der Widerstandsbahn des Potentiometers in Verbindung steht, liegt das Potential am Abgriff zwischen dem Eingangspotential und dem Massepotential am Potentiometer. Für diesen Fall kann der Kennlinienbildner normal arbeiten. Wenn allerdings durch die Potentialsteuerschaltung ein höheres Potential an den Abgriff angelegt wird, wird dieser Zustand vom Komparator erfaßt. Dieser schaltet daraufhin den Ausgang der Ausgangsschaltung auf ein vorbestimmtes Potential, beispielsweise direkt oder über einen Halbleiter an Masse.

Mit Vorteil ist die Schalteinrichtung als Halbleiterschalter ausgebildet. Dadurch werden mechanische Bestandteile vermieden.

Die Erfindung wird im folgenden anhand eines bevorzugten Ausführungsbeispiels in Verbindung mit der Zeichnung beschrieben. Darin zeigen:

Fig. 1 eine Prinzipdarstellung der Ausgangsschaltung,

Fig. 2 eine Schaltungsanordnung und

Fig. 3 eine Kennlinie eines Kennlinienbildners.

Ein Potentiometer R1 wird an seinem Eingang 2 mit einer Spannung $U_{ref}$ versorgt. Der andere Anschluß 3 des Potentiometers ist mit Masse M verbunden. Am Abgriff 1 des Potentiometers läßt sich ein Potential abnehmen, das sich zwischen dem Potential $U_{ref}$ am Eingang 2 und dem Potential M am Anschluß 3 des Potentiometers bewegt. Das Verhältnis des Potentials am Abgriff 1 zum Potential am Eingang 2 erlaubt eine Aussage über die Stellung des Abgriffs des Potentiometers auf einer Widerstandsbahn 4 des Potentiometers. Ein derartiges Potentiometer R1 kann beispielsweise als Leitplastikpotentiometer ausgebildet sein und im Kraftfahrzeug als Lenkwinkelsensor verwendet werden. Ein Leitplastikpotentiometer hat keine Anschläge, so daß der Abgriff 1 auch in Bereiche 5, 6 geführt werden kann, in denen sich der Abgriff nicht mehr auf der Widerstandsbahn 4 befindet. In diesem Fall ist der Stromfluß über den Abgriff 1 unterbrochen.

Um zu verhindern, daß in diesem Fall am Abgriff 1 ein undefiniertes Potential entsteht, ist eine Potentialsteuerschaltung 7 vorgesehen, die am Abgriff ein definiertes Potential erzeugt, wenn der Stromfluß über den Abgriff 1 unterbrochen ist.

Der Abgriff 1 ist mit einem Eingang eines Kennlinienbildners 8 verbunden, dessen Ausgang mit dem Ausgang 9 der Ausgangsschaltung 10 verbunden ist.

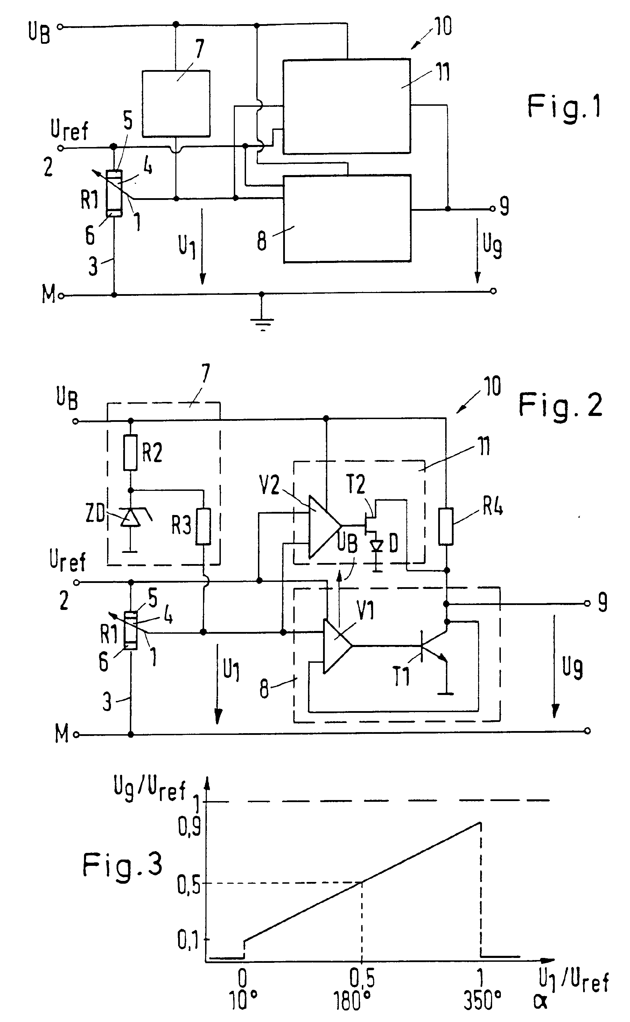

Der Kennlinienbildner erzeugt in Abhängigkeit vom Potential an seinem Eingang ein Ausgangspotential an seinem Ausgang, wobei der Zusammenhang in Fig. 3 dargestellt ist und folgender Funktion folgt:

$$P_A = P_O (P_E - P_O) \times v$$

wobei $P_O$ ein vorbestimmtes drittes Potential und v ein Verstärkungsfaktor kleiner als 1 ist. Aus Fig. 3 ist ebenfalls zu entnehmen, daß sich der Wert Null der Eingangsspannung des Kennlinienbildners 8 bereits dann ergibt, wenn das Potentiometer auf einen Drehwinkel von 10° eingestellt ist. Umgekehrt ergibt sich die maximale Eingangsspannung des Kennlinienbildners 8 dann, wenn das Potentiometer auf einen Drehwinkel von 350° eingestellt ist. Bei der minimalen Eingangsspannung ist die Ausgangsspannung nicht gleich Null sondern beträgt beispielsweise 10% einer Bezugsspannung. Umgekehrt ist der Maximalwert der Ausgangsspannung, der ausgegeben wird, wenn die maximale Eingangsspannung angelegt wird, nur 90% der Bezugsspannung. Am oberen und am unteren Ende der Kennlinie besteht also jeweils eine Reserve von ca. 10% der Bezugsspannung, die von einer nichtdargestellten Auswerteschaltung ausgewertet werden kann, um einen Leitungsbruch oder einen Kurzschluß zu erkennen.

Für den Fall, daß der Abgriff 1 des Potentiometers in die Bereiche 5, 6 geführt wird, wird das Potential bzw. die Spannung am Eingang des Kennlinienbildners 8 durch die Potentialsteuerung 7 angehoben und überschreitet damit den zulässigen Eingangsbereich. Für diesen Fall ist eine Hilfsschaltung 11 vorgesehen, die das Potential $U_1$ am Abgriff 1 überwacht und den Ausgang 9 der Ausgangsschaltung 10 auf ein vorbestimmtes Potential bringt, wenn das Potential $U_1$ einen vorbestimmten Wert überschreitet.

Der nähere Aufbau der Schaltungsanordnung ist in Fig. 2 dargestellt. Die Potentialsteuerschaltung 7 weist eine Konstantspannungsquelle auf, die durch eine Reihenschaltung einer Zenerdiode ZD mit einem Widerstand R2 gebildet ist, die zwischen eine Versorgungsspannung $U_B$ und Masse geschaltet ist. Die durch die Zenerdiode ZD erzeugte Spannung wird über einen Widerstand R3 hochohmig an den Abgriff 1 des Potentiometers R1 geführt. Der Widerstandswert von R3 ist etwa um den Faktor 1000 größer als der Widerstandswert zwischen den beiden Anschlüssen 2 und 3 des Potentiometers R1. Solange ein Strom über den Abgriff 1 fließen kann, fällt eine der Zenerspannung entsprechende Spannung am Widerstand R3 ab. Wird der Stromfluß über den Abgriff 1 unterbrochen, nimmt das Potential am Abgriff 1 den Wert der Zenerspannung an, da der Kennlinienbildner 8 und die Hilfsschaltung 11 sehr hochohmige Eingänge haben, die praktisch keinen Stromfluß erlauben.

Solange der Abgriff 1 aber mit der Widerstandsbahn 4 in Verbindung steht, wird das Potential am Abgriff 1 durch einen Operationsverstärker V1 hochohmig abgegriffen und über einen Widerstand R4 und einen Transistor T1 niederohmig am Ausgang 9 der Ausgangsschaltung 10 zur Verfügung gestellt. Der Zusammenhang zwischen der Spannung $U_1$ und der Spannung $U_9$ ergibt sich aus Fig. 3. Der Verstärker V1 verstärkt die Differenz zwischen seiner Eingangsspannung $U_1$ und einem virtuellen Nullpunkt, der beispielsweise durch $U_{ref}/2$ gebildet werden kann, mit einem Verstärkungsfaktor v von kleiner 1 und addiert die so verstärkte Differenz zum virtuellen Nullpunkt hinzu.

Die Hilfsschaltung weist einen als Komparator ausgebildeten Operationsverstärker V2 auf, der das Potential U1 am Abgriff 1 des Potentiometers R1 mit dem Potential $U_{ref}$ am Eingang 2 des Potentiometers vergleicht. Solange der Abgriff 1 mit der Widerstandsbahn 4 des Potentiometers R1 Kontakt hat, ist das Potential $U_1$ kleiner als das Potential $U_{ref}$. Sobald der Abgriff 1 die Widerstandsbahn 4 verläßt und in die Bereiche 5 oder 6 geführt wird, nimmt das Potential $U_1$ das durch die Zenerdiode ZD definierte Potential an, das höher als $U_{ref}$ ist. Dieser Zustand wird durch den Operationsverstärker $V_2$ erfaßt, der daraufhin einen Schalter T2, beispielsweise einen Transistor schaltet und den Ausgang 9 der Ausgangsschaltung 10 direkt oder über einer Diode D mit Masse verbindet. Durch die Diode D kann dabei eine definierte Spannung am Ausgang 9 eingestellt werden. Selbstverständlich kann man die dargestellte Kombination aus Feldeffekttransistor T2 und Diode D durch einen Bipolartransistor ersetzen, um den Spannungsabfall über den Transistor zur Festlegung der Spannung $U_9$ zu verwenden.

## Patentansprüche

1. Ausgangsschaltung für ein Potentiometer (R1), insbesondere eines in einer Reihenschaltung mit weiteren Widerständen liegenden Potentiometers (R1), welches zwischen einer Spannungsversorgung ($U_{REF}$) und Masse (M) liegt, wobei die zwischen Potentiometerabgriff (1) und Masse (M) abfallende Spannung ein Eingangspotential ($U_1$) der Ausgangsschaltung (10) darstellt, dadurch gekennzeichnet, daß in Abhängigkeit von der Stellung des Abgriffs (1) des Potentiometers (R1) am Ausgang (9) ein Potential ($U_9$) erzeugt wird, mit einem Kennlinienbildner (8), dessen Eingang mit dem Abgriff (1) des Potentiometers und dessen Ausgang mit dem Ausgang (9) der Ausgangsschaltung (10) verbunden ist und der an seinem Ausgang ein Ausgangspotential in Abhängigkeit von dem Eingangspotential ($U_1$) an seinem Eingang erzeugt, wobei sich das Ausgangspotential in einem Ausgangsbereich von einem vorbestimmten Minimalwert bis zu einem vorbestimmten Maximalwert bewegt, mit einer Potentialsteuerschaltung (7), die bei unterbrochenem Stromfluß über den Abgriff (1) des Potentiometers (R1) am Abgriff ein vorbestimmtes erstes Potential erzeugt, das größer als das Potentiometerpotential am Eingang (2) des Potentiometers (R1) ist, und mit einer Hilfsschaltung (11), die parallel zum Kennlinienbildner (8) zwischen den Abgriff (1) des Potentiometers und den Ausgang (9) der Ausgangsschaltung (10) geschaltet ist und den Ausgang der Ausgangsschaltung auf ein vorbestimmtes zweites Potential, das außerhalb des Ausgangsbereichs des Kennlinienbildners (8) liegt, bringt, wenn das Potential am Abgriff (1) des Potentiometers (R1) einen vorbestimmten Bereich verläßt.

2. Schaltung nach Anspruch 1, dadurch gekennzeichnet, daß der Kennlinienbildner (8) eine Ausgangsspannung erzeugt, die linear von der Eingangsspannung abhängt.

3. Schaltung nach Anspruch 1 oder 2, dadurch gekennzeichnet, daß der Ausgangsbereich des Kennlinienbildners (8) kleiner als sein Eingangsbereich ist.

4. Schaltung nach einem der Ansprüche 1 bis 3, dadurch gekennzeichnet, daß das Potential ($P_A$) am Ausgang des Kennlinienbildners (8) durch folgende Funktion vom Potential ($P_E$) am Eingang des Kennlinienbildners abhängt:
$$P_A = P_O + (P_E - P_O) \times v$$
wobei $P_O$ ein vorbestimmtes drittes Potential und v ein Verstärkungsfaktor kleiner 1 ist.

5. Schaltung nach einem der Ansprüche 1 bis 4, dadurch gekennzeichnet, daß die Potentialsteuerschaltung (7) eine insbesondere eine Zenerdiode (ZD) aufweisende Konstantspannungsquelle aufweist, deren Ausgang über einen Widerstand (R3) hochohmig mit dem Abgriff (1) des Potentiometers verbunden ist.

6. Schaltung nach Anspruch 5, dadurch gekennzeichnet, daß der Widerstandswert des Widerstands (R3) um einen Faktor in der Größenordnung von 1000 größer ist als der Gesamtwiderstandswert des Potentiometers (R1).

7. Schaltung nach einem der Ansprüche 1 bis 6, dadurch gekennzeichnet, daß die Hilfsschaltung (11) einen Komparator (V2) aufweist, der das Potential am Abgriff (1) des Potentiometers (R1) mit einem Bezugspotential ($U_{ref}$) vergleicht und ein Ausgangssignal erzeugt, wenn das Potential am Abgriff (1) in einer vorbestimmten Richtung vom Bezugspotential ($U_{ref}$) abweicht, wobei eine Schalteinrichtung (T2) vorgesehen ist, die auf das Ausgangssignal des Komparators (V2) hin den Ausgang (9) der Ausgangsschaltung (10) auf das vorbestimmte zweite Potential bringt.

8. Schaltung nach Anspruch 7, dadurch gekennzeichnet, daß das Bezugspotential das Eingangspotential ($U_{ref}$) des Potentiometers (R1) ist.

9. Schaltungsanordnung nach Anspruch 7 oder 8, dadurch gekennzeichnet, daß die Schalteinrichtung als Halbleiterschalter (T2) ausgebildet ist.

## Claims

1. Output circuit for a potentiometer (R1), particularly a potentiometer (R1) in series-parallel connection with other resistors, situated between a voltage supply ($U_{REF}$) and earth (M), the falling voltage between potentiometer tap (1) and earth (M) representing an input potential ($U_1$) of the output circuit (10),
characterised in that a potential ($U_9$) is generated at the output (9) in response to the position of the tap (1) of the potentiometer (R1), and comprising a characteristic generator (8) whose input is connected to the potentiometer tap (1) and whose output is connected to the output (9) of the output circuit (10) and which at its output generates an output potential in response to the input potential ($U_1$) at its input, the output potential moving in an output range from a preset minimum value to a preset maximum value, also comprising a potential control circuit (7) which when the flow of current is interrupted via the tap (1) of the potentiomete (R1) generates at the tap a preset first potential that is greater than the potentiometer potential at the input (2) of the potentiometer (R1), and further comprising an auxiliary circuit (11) which is connected parallel to the characteristic generator (8) between the potentiometer tap (1) and the output (9) of the output circuit (10) and brings the output of the output circuit to a preset second potential outside the output range of the characteristic generator (8) whenever the potential at the tap (1) of the potentiometer (R1) leaves a preset range.

2. Circuit according to claim 1, characterised in that the characteristic generator (8) generates an output voltage that is a linear function of the input voltage.

3. Circuit according to claim 1 or 2, characterised in that the output range of the characteristic generator (8) is smaller than its input range.

4. Circuit according to any of claims 1 to 3, characterised in that the potential ($P_A$) at the output of the characteristic generator (8) is a function of the potential ($P_E$) at the input of the characteristic generator, as follows:
$$P_A = P_0 + (P_E - P_0) \times v$$
where $P_0$ is a preset third potential and v an amplification factor smaller than 1.

5. Circuit according to any of claims 1 to 4, characterised in that the potential control circuit (7) has a constant-voltage source having in particular a Zener diode (ZD), and the output of said source is connected with high resistance to the potentiometer tap (1) via a resistor (R3).

6. Circuit according to claim 5, characterised in that the resistance of the resistor (R3) is greater by a factor in the order of 1000 than the overall resistance of the potentiometer (R1).

7. Circuit according to any of claims 1 to 6, characterised in that the auxiliary circuit (11) has a comparator (V2) which compares the potential at the tap (1) of the potentiometer (R1) with a reference potential ($U_{ref}$) and generates an output signal whenever the potential at the tap (1) deviates in a preset direction from the reference potential ($U_{ref}$), there being provided a switching device (T2) which in response to the output signal of the comparator (V2) brings the output (9) of the output circuit (10) to the preset second potential.

8. Circuit according to claim 7, characterised in that the reference potential is the input potential ($U_{ref}$) of the potentiometer (R1).

9. Circuit arrangement according to claim 7 or 8, characterised in that the switching device is in the form of a semiconductor switch (T2).

## Revendications

1. Circuit de sortie pour un potentiomètre (R1), en particulier un potentiomètre (R1) branché en série avec d'autres résistances, et intercalé entre une alimentation en tension ($U_{REF}$) et la masse (M), la tension, décroissant entre la prise (1) du potentiomètre et la masse (M), représentant un potentiel d'entrée ($U_1$) du circuit de sortie (10), caractérisé par le fait qu'un potentiel ($U_9$) est engendré à la sortie (9), en fonction de la position de la prise (1) du potentiomètre (R1), avec un formateur (8) de courbes caractéristiques dont l'entrée et la sortie sont raccordées, respectivement, à la prise (1) du potentiomètre et à la sortie (9) du circuit de sortie (10), et qui engendre un potentiel de sortie, à sa sortie, en fonction du potentiel d'en-

trée ($U_1$) appliqué à son entrée, le potentiel de sortie passant, dans une plage de sortie, d'une valeur minimale prédéterminée à une valeur maximale prédéterminée ; avec un circuit (7) de commande de potentiels engendrant par l'intermédiaire de la prise (1) du potentiomètre (R1) lorsque la circulation du courant est interrompue, sur ladite prise, un premier potentiel prédéterminé qui excède le potentiel appliqué à l'entrée (2) du potentiomètre (R1) ; et avec un circuit auxiliaire (11) qui est branché en parallèle avec le formateur (8) de courbes caractéristiques, entre la prise (1) du potentiomètre et la sortie (9) du circuit de sortie (10), et qui fait passer la sortie du circuit de sortie à un deuxième potentiel prédéterminé, situé en dehors de la plage de sortie du formateur (8) de courbes caractéristiques, lorsque le potentiel appliqué à la prise (1) du potentiomètre (R1) sort d'une plage prédéterminée.

2. Circuit selon la revendication 1, caractérisé par le fait que le formateur (8) de courbes caractéristiques engendre une tension de sortie dépendant linéairement de la tension d'entrée.

3. Circuit selon la revendication 1 ou 2, caractérisé par le fait que la plage de sortie du formateur (8) de courbes caractéristiques est plus petite que sa plage d'entrée.

4. Circuit selon l'une des revendications 1 à 3, caractérisé par le fait que le potentiel ($P_A$) appliqué à la sortie du formateur (8) de courbes caractéristiques dépend du potentiel ($P_E$) appliqué à l'entrée dudit formateur de courbes caractéristiques, selon la fonction suivante :
$$P_A = P_0 + (P_E - P_0) \times v,$$
dans laquelle $P_0$ est un troisième potentiel prédéterminé, et $\underline{v}$ est un facteur d'amplification inférieur à 1.

5. Circuit selon l'une des revendications 1 à 4, caractérisé par le fait que le circuit (7) de commande de potentiels présente une source de tension constante qui est notamment munie d'une diode de Zener (ZD) et dont la sortie est raccordée avec forte valeur ohmique, par l'intermédiaire d'une résistance (R3), à la prise (1) du potentiomètre.

6. Circuit selon la revendication 5, caractérisé par le fait que la valeur résistive de la résistance (R3) excède, d'un facteur de l'ordre de 1 000, la valeur résistive totale du potentiomètre (R1).

7. Circuit selon l'une des revendications 1 à 6, caractérisé par le fait que le circuit auxiliaire (11) présente un comparateur (V2) qui compare, à un potentiel de référence ($U_{ref}$), le potentiel appliqué à la prise (1) du potentiomètre (R1) et qui délivre un signal de sortie lorsque le potentiel appliqué à la prise (1) s'écarte, du potentiel de référence ($U_{ref}$), dans une direction prédéterminée, auquel cas il est prévu un dispositif de commutation (T2) qui, sur la base du signal de sortie du comparateur (V2), fait passer la sortie (9) du circuit de sortie (10) au deuxième potentiel prédéterminé.

8. Circuit selon la revendication 7, caractérisé par le fait que le potentiel de référence est le potentiel d'entrée ($U_{ref}$) du potentiomètre (R1).

9. Circuit selon la revendication 7 ou 8, caractérisé par le fait que le dispositif de commutation est réalisé sous la forme d'un commutateur (T2) à semi-conducteur.

Fig.1

Fig.2

Fig.3